# EUROPÄISCHE PATENTANMELDUNG

(11) **EP 4 220 203 A1**
(43) Veröffentlichungstag der Anmeldung: **02.08.2023**
(21) Anmeldenummer: 23166526.6
(22) Anmeldetag: 09.02.2018
(51) Int. Cl.: G01R 31/28

(54) **PRÜFVORRICHTUNG UND VERFAHREN ZUM PRÜFEN VON LEITERPLATTEN**

(30) Priorität: 10.02.2017 DE 102017102700
(62) Teilanmeldung aus: 18708909.9
(71) Anmelder: atg Luther & Maelzer GmbH, 97877 Wertheim/Reicholzheim (DE)
(72) Erfinder: WEINDEL, Christian, 75248 Ölbronn-Dürm (DE); OTT, Bernd-Ulrich, 74653 Künzelsau (DE); BRANDT, Peter, 97084 Würzburg (DE)
(74) Vertreter: HGF

(57) **Zusammenfassung**

Die vorliegende Erfindung betrifft eine Prüfvorrichtung und ein Verfahren zum Testen von Leiterplatten, insbesondere von unbestückten oder teilbestückten Leiterplatten. Die Prüfvorrichtung ist ein Fingertester mit einem Shuttle oder zwei Teilshuttle, welche alternierend eine zu testende Leiterplatte zu einem Prüfbereich verfahren können. Zudem können die Teilshuttle zum gemeinsamen Halten einer großen Leiterplatte verwendet werden.

## Beschreibung

Die vorliegende Erfindung betrifft eine Prüfvorrichtung und Verfahren zum Prüfen von Leiterplatten.

Prüfvorrichtungen zum Prüfen von Leiterplatten können grundsätzlich in zwei Gruppen eingeteilt werden, die Gruppe der Fingertester (Flying Probe) und die Gruppe der Paralleltester. Die Paralleltester sind Prüfvorrichtungen, die mittels eines Adapters alle oder zumindest die meisten Kontaktstellen einer zu prüfenden Leiterplatte gleichzeitig kontaktieren. Fingertester sind Prüfvorrichtungen zum Testen von unbestückten, teilbestückten oder bestückten Leiterplatten, die mit zwei oder mehreren Prüffingern die einzelnen Kontaktstellen sequenziell abtasten.

Die Prüffinger sind in der Regel an einem Schlitten befestigt, welcher entlang von Traversen verfahrbar ist, wobei die Traversen wiederum auf Führungsschienen geführt und verfahrbar sein können. Die Prüffinger weisen jeweils einen Schwenkarm auf, an dessen Ende eine Kontaktspitze zum Kontaktieren einer Leiterplatte ausgebildet ist. Die Prüffinger können durch Verfahren des Schlittens und Drehen des Schwenkarmes somit mit ihren Kontaktspitzen an jede beliebige Stelle eines in der Regel rechteckförmigen Prüffeldes positioniert werden. Zum Kontaktieren einer Kontaktstelle einer zu prüfenden Leiterplatte ist entweder der Schlitten an der Traverse vertikal verschieblich oder die Prüfsonde am Schlitten vertikal beweglich ausgebildet, so dass der Prüffinger von oben bzw. von unten auf die Kontaktstelle der Leiterplatte, dem Leiterplattentestpunkt, gesetzt werden kann.

Ein Fingertester ist in der EP 0 468 153 A1 und ein Verfahren zum Prüfen von Leiterplatten mittels eines Fingertesters ist in der EP 0 853 242 A1 beschrieben. Prüfsonden für Fingertester gehen aus der EP 1 451 594 B1, der US 6,384,614 B1, der WO 03/096037 A1 und der EP 0 990 912 A2 hervor.

Üblicherweise werden für einen derartigen Fingertester mindestens zwei verfahrbare Kontaktfinger vorgesehen, um in einer ersten Koordinatenrichtung entlang der Traversenachse voneinander beabstandete Prüfpunkte erreichen zu können, und es werden mehrere Traversen oberhalb des Prüffeldes und (jedenfalls für die Prüfung beidseitig bedruckter Leiterplatten) mehrere Traversen unterhalb des Prüffeldes vorgesehen, um in einer zweiten Koordinatenrichtung quer zur Traversenachse voneinander beabstandete Prüfpunkte erreichen zu können. Grundsätzlich kann man auch lediglich mit einem einzelnen Testfinger eine Leiterbahn testen, wenn man kapazitiv misst. In diesem Fall würde theoretisch nur ein Testfinger benötigt. Es wird aber bevorzugt, zwei Testfinger an einer Schiene anzuordnen, da man bei einer ohmschen Messung einen geschlossenen Stromkreis braucht und damit zwei Testfinger benötigt werden. Für den Einsatz automatisierter Prüfverfahren mit einem Fingertester ist es wesentlich, dass die Relativpositionen der Traversen sowohl zueinander als auch zu dem Prüffeld genau bekannt sind. Bei dem in EP 0 468 153 A1 beschriebenen Fingertester sind die Traversen in einem Gestell - senkrecht zur Verfahrrichtung der Testfinger - verfahrbar gelagert. Aufgrund eines oft nicht vermeidbaren Spiels im Verfahren der Traversen weist der Abstand der Traversen eine gewisse Schwankungsbreite auf, und je nach dem eingesetzten Antriebssystem kann es aufgrund von Schlupferscheinungen vorkommen, dass der Abstand der Traversen aus einem vorgegebenen Toleranzfeld herauswandert und nachjustiert werden muss. Die damit verbundenen Justierungs- und Kalibrierungsvorgänge für wenigstens vier Traversen sind aufwändig und oft mit Ungenauigkeiten behaftet.

Es sind auch Fingertester bekannt, bei welchen die Traversen in einem Gestell ortsfest angeordnet sind. Da die Traversen einzelnen an einem Gestell sowohl ober- als auch unterhalb der Leiterplatte eingehängt sind, müssen sie einzeln sorgfältig justiert werden. Eine Länge der Schwenkarme kann im Hinblick auf einen Abstand zwischen den Traversen optimiert sein, um das Prüffeld zwischen den Traversen optimal erreichen zu können. Falls ein solcher Fingertester an geänderte Prozessbedingungen anzupassen ist, etwa weil die Abtastdichte erhöht oder erniedrigt werden soll, sind zusätzliche Traversen zu montieren bzw. vorhandene Traversen zu entfernen bzw. umzumontieren. Dabei ist ebenfalls ein erheblicher Aufwand für die Justierung der Traversen zueinander und zu dem Prüffeld und die Kalibrierung der Software erforderlich.

Aus der EP 0 458 280 A2 geht eine Vorrichtung zum Testen von Leiterplatten hervor, welche eine Vielzahl von separat verfahrbaren Traversen aufweist, wobei an jeder Traverse ein

Prüfkopf mit einem Kontaktfinger zum Kontaktieren einer Kontaktstelle einer Leiterplatte vorgesehen ist.

Aus der EP 1 217 382 A2 geht eine weitere Vorrichtung zum Testen von Leiterplatten hervor, welche verfahrbare Traversen aufweist. An den verfahrbaren Traversen ist jeweils ein Prüfkopf beweglich angeordnet, an dem ein Kontaktfinger zum Kontaktieren eines Testpunktes einer Leiterplatte angeordnet ist.

Da über die Leiterbahnen von Leiterplatten auch Hochfrequenzsignale übertragen werden, ergeben sich bei der fortschreitenden Miniaturisierung der Leiterplatten erhebliche Probleme. Damit ein hochfrequentes Signal korrekt über eine Leiterbahn übertragen werden kann, darf die Leiterbahn keinen zu großen elektrischen Widerstand besitzen. Typischerweise muss der Widerstand von Leiterbahnen für hochfrequente Signale kleiner oder gleich einem vorbestimmten Widerstand sein, der im Bereich von 1 µΩ bis 100 Ω liegen kann. Bei der Herstellung von Leiterplatten kann jedoch nicht immer sichergestellt werden, dass dieser Widerstandswert eingehalten wird.

Auch Leiterbahnen, an welche im Betrieb ein hoher Strom angelegt wird, sollten keine Bereiche mit hohem Widerstand, insbesondere mit einem Widerstand größer als 1 µΩ bis 100 Ω besitzen, da bei einem derartigen Widerstand eine Spannung abfallen würde, die zu einer Beschädigung der Leiterbahn führen kann.

Beim Testen von derartigen Leiterbahnen wird eine sogenannte Vier-Draht-Messung durchgeführt. Hierzu werden bei einem Fingertester an den Testfingern Prüfsonden mit zwei Prüfspitzen vorgesehen. Die zu untersuchende Leiterbahn wird an zwei Leiterplattentestpunkten mit jeweils einer derartigen Prüfsonde kontaktiert, wobei über jeweils eine der Prüfspitzen der Prüfsonden ein Strom in die Leiterbahn eingespeist wird und über die andere Prüfspitze der Prüfsonde die an der Leiterbahn abfallende Spannung gemessen wird. Hiermit können mit hoher Zuverlässigkeit Widerstände im Bereich von kleiner oder gleich 1 µΩ bis 1 kΩ detektiert werden.

Durch die zunehmende Miniaturisierung der Leiterplatten und die damit einhergehende Verkleinerung der Leiterplattentestpunkte ist es schwierig, mit einer solchen Doppelspitze einen Leiterplattentestpunkt korrekt zu kontaktieren, d.h., dass beide Spitzen der Prüfsonde in elektrischen Kontakt mit dem Leiterplattentestpunkt stehen.

Aus der WO 2014/140029 A1 geht ein weiterer Fingertester hervor, der eine Traverseneinheit aufweist, die mit zumindest einer Traverse ausgebildet ist, welche ein Prüffeld, in dem eine zu prüfende Leiterplatte angeordnet werden kann, überspannt. An der Traverse sind Schlitten vorgesehen, mit welchen Testfinger linear verfahrbar sind. Diese Traverseneinheit zeichnet sich dadurch aus, dass zumindest zwei voneinander unabhängige Linearführungen zum Führen jeweils eines solchen Schlittens vorgesehen sind. Eine solche Traverseneinheit kann auch mit zwei, das Prüffeld überspannenden Traversen ausgebildet sein, wobei eine der beiden Traversen auf einer Seite und die andere Traverse auf der anderen Seite des Prüffeldes verlaufen. Die Traverseneinheit bildet bei dieser Ausführungsform einen ringförmigen Körper, wobei sich das Prüffeld durch die Öffnung des ringförmigen Körpers hindurch erstreckt.

Aus der DE 44 41 347 A1 und der US 6,384,614 B2 gehen Prüfvorrichtungen hervor, mit welchen eine so genannte Vier-Draht-Messung durchgeführt werde kann. Hierbei werden die Leiterbahnen an den Enden jeweils zweifach kontaktiert, wobei mit einem Paar Kontaktelemente ein Strom eingespeist wird und mit dem anderen Paar Kontaktelemente die hierdurch abfallende Spannung gemessen wird. Mit einer solchen Vier-Draht-Messung können kleine Widerstände von beispielsweise 1 µΩ bis 10 kΩ sehr präzise gemessen werden. Dies ist vor allem dann zweckmäßig, wenn die Leiterbahnen zum Übertragen von Hochfrequenzsignalen oder großen Strömen verwendet werden.

Aus der WO 2006/133808 A1 geht ein Verfahren zum Testen von unbestückten, großflächigen Leiterplatten mit einem Fingertester hervor. Die Leiterplatten werden in mehrere Segmente unterteilt getestet, wobei Leiterbahnen, die sich über ein Segment hinaus erstrecken, mittels kapazitiver Messung der in dem jeweiligen Segment befindlichen Endpunkte getestet werden. Eine Unterbrechung der Leiterbahn wird festgestellt, indem sich ein Messwert von anderen kapazitiven Messwerten derselben Leiterbahn unterscheidet. Zum Testen der unterschiedlichen Segmente der Leiterplatte wird die Leiterplatte im Fingertester verschoben.

Beim Prüfen von Leiterplatten unterscheidet man das Prüfen von unbestückten Leiterplatten und das Prüfen von bestückten Leiterplatten bzw. Baugruppen. Baugruppen sind Leiterplatten, die mit den entsprechenden elektronischen Bauteilen bestückt sind. Hier werden bestimmte Schaltkreise durch Anlegen von Funktionssignalen an bestimmten Kontaktstellen getestet, wobei bei anderen Kontaktstellen die Antwortsignale auf die Funktionssignale abgenommen werden. Diese Testverfahren werden als In-Circuit-Test bezeichnet. Ein solch ein In-Circuit-Test zeichnet sich dadurch aus, dass wenige Kontaktstellen kontaktiert werden müssen, wobei jedoch sehr komplexe Signalfunktionen oftmals erzeugt werden. Bei unbestückten Leiterplatten werden die einzelnen Leiterbahnen getestet, ob sie eine Unterbrechung besitzen oder ob sie mit einer anderen Leiterbahn kurzgeschlossen sind. Dies kann mittels einer ohmschen Messung ausgeführt werden. Es sind jedoch auch Verfahren bekannt, bei welchen Unterbrechungen und Kurzschlüsse mittels kapazitiver Messungen erfasst werden. Im Unterschied zu In-Circuit-Tests werden hier alle oder fast alle Kontaktstellen der Leiterbahnen ein- oder mehrfach kontaktiert. Bei großflächigen Leiterplatten können einige Zehntausend, wenn nicht sogar mehr als Hundertausend Kontaktstellen kontaktiert werden. Weiterhin gewinnen zunehmend teilbestückte Leiterplatten an Bedeutung, bei welchen die Leiterplatte mit einzelnen wenigen elektronischen Bauteilen, wie zum Beispiel einzelne Widerstände, Kondensatoren oder Transistoren bestückt ist. Das Testen von teilbestückten Leiterplatten ist dem Testen von unbestückten Leiterplatten ähnlich, da die vom In-Circuit-Test bekannten Funktionstests hier in der Regel nicht ausgeführt werden können.

Der vorliegenden Erfindung liegt die Aufgabe zugrunde, eine Prüfvorrichtung sowie ein Verfahren zum Testen von Leiterplatten zu schaffen, bei welchen eine zu testende Leiterplatte mit mehreren Prüffingern abgetastet wird (Fingertester), wobei auf einfache Art und Weise ein hoher Durchsatz und eine hohe Flexibilität geschaffen werden soll.

Weiterhin liegt der Erfindung die Aufgabe zugrunde, eine Prüfvorrichtung und ein Verfahren zum Testen von Leiterplatten zu schaffen, bei welchen eine zu testende Leiterplatte mit Prüffingern abgetastet wird, wobei auf einfache Art und Weise auch mehrere in Reihe angeordneter Leiterplattentestpunkte einer Leiterplatte zuverlässig bei einer sehr dichten Anordnung kontaktierbar sind.

Eine oder mehrere der vorbezeichneten Aufgaben werden durch die Gegenstände der unabhängigen Ansprüche gelöst. Vorteilhafte Ausgestaltungen sind in den jeweiligen Unteransprüchen angegeben.

Nach einem ersten Aspekt der vorliegenden Erfindung wird die Prüfvorrichtung zum Testen von Leiterplatten, insbesondere von unbestückten oder teilbestückten Leiterplatten, vorgesehen, wobei die Prüfvorrichtung mehrere Prüffinger aufweist, die zum Kontaktieren von Leiterplattentestpunkten einer zu testenden Leiterplatte ausgebildet sind. Die Prüffinger sind jeweils mit einer Prüfsonde versehen, wobei die Prüffinger derart beweglich sind, dass sie mit ihren Prüfsonden in einem vorbestimmten Prüfbereich beliebige Punkte kontaktieren können. Es ist ein Shuttle zum Befördern einer Leiterplatte zwischen einem Aufnahmebereich und dem Prüfbereich vorgesehen.

Diese Prüfvorrichtung zeichnet sich dadurch aus, dass das Shuttle aus zwei Teilshuttle ausgebildet ist, welche in einer Ebene jeweils entlang einer Verfahrstrecke zwischen dem Aufnahmebereich und dem Prüfbereich verfahrbar angeordnet sind, wobei die Verfahrstrecken parallel und nebeneinander zueinander verlaufen und die Teilshuttle jeweils einen Haltebereich aufweisen, in welchen jeweils eine Leiterplatte mittels einem oder mehrerer Halteelemente gehalten werden kann.

Mit einem solchen Teilshuttle kann eine Leiterplatte geprüft werden, wobei die sich im Teilshuttle befindliche Leiterplatte mittels der Prüffinger kontaktiert wird. Gleichzeitig kann das andere Teilshuttle entladen und mit einer weiteren Leiterplatte beladen werden. Diese Leiterplatte kann dann im Teilshuttle für einen weiteren Prüfvorgang vorbereitet werden, indem sie beispielsweise mit einer Kamera abgetastet wird, um die Position der Leiterplatte bezüglich des Teilshuttles zu bestimmen. Dieses Abtasten der Position der Leiterplatte wird häufig als Kalibrieren bezeichnet.

Prüfvorrichtungen mit Prüffingern, welche auch als Fingertester bezeichnet werden, sind sehr flexibel, da sie grundsätzlich zum Testen von Leiterplatten mit einem beliebigen Muster von Leiterplattentestpunkten geeignet sind. Die einzelnen Prüffinger tasten die Leiterplattentestpunkte sequenziell ab. Im Vergleich zu Paralleltestern besteht der grundsätzliche Nachteil von Fingertestern darin, dass aufgrund des sequenziellen Abtastens der Leiterplattentestpunkte die Testgeschwindigkeit wesentlich geringer ist. Daher besteht bei Testfingern immer das Ziel, den Durchsatz zu steigern. Da bei dieser Prüfvorrichtung zwei Teilshuttle vorgesehen sind, kann immer eine Leiterplatte im Prüfbereich einem Prüfvorgang unterzogen werden, wohingegen am anderen Teilshuttle eine weitere Leiterplatte für den Prüfvorgang vorbereitet werden kann. Hierdurch sind die Pausenzeiten zwischen zwei Prüfvorgängen sehr gering. Bei kleinen Leiterplatten ist der Zeitbedarf zum Entladen und Beladen und gegebenenfalls zum Kalibrieren der Leiterplatte relativ groß im Vergleich zum Zeitbedarf des eigentlichen Prüfvorganges, weshalb bei kleinen Leiterplatten das Vorsehen zweiter Teilshuttle den Durchsatz erheblich steigert.

Vorzugsweise sind an der zum jeweils anderen Teilshuttle weisenden Seite die Teilshuttle offen ausgebildet, so dass eine Leiterplatte sich über beide Haltebereiche hinweg erstrecken und von beiden Teilshuttle gleichzeitig gehalten werden kann.

Da die Verfahrstrecken parallel und nebeneinander angeordnet sind, können diese gemeinsam zum Transport einer großen Leiterplatte verwendet werden. Bei einer großen Leiterplatte ist der Zeitbedarf des Prüfvorganges wesentlich größer als der zum Be- und Entladen notwendige Zeitbedarf. Dadurch, dass die beiden Teilshuttle gemeinsam zum Transport einer großen Leiterplatte eingesetzt werden können, erlaubt die Prüfvorrichtung das Testen unterschiedlich großer Leiterplatten, wobei bei kleinen Leiterplatten der Durchsatz aufgrund der doppelten Teilshuttle erheblich gesteigert werden kann.

Diese Prüfvorrichtung ist somit flexibel für unterschiedlich große Leiterplatten einsetzbar als auch bezüglich des Durchsatzes von kleinen Leiterplatten optimiert.

Ein Teilshuttle kann zwei parallele Haltearme aufweisen, die zwischen sich den Haltebereich zum Aufnehmen jeweils einer Leiterplatte begrenzen. Die beiden Haltearme können in ihrem Abstand zueinander veränderbar ausgebildet sein.

Die beiden Haltearme eines Teilshuttles können jeweils an einem Schlitten befestigt sein, der entlang einer Shuttleschiene verfahrbar ist. Die Haltearme bilden somit separate Körper.

Die Haltearme können auch Bestandteil eines in der Draufsicht C-förmigen Rahmens sein, welcher beispielsweise lediglich mit einem einzigen Schlitten entlang von einer Shuttleschiene verfahrbar ist.

Sind die Haltearme jeweils an einem Schlitten befestigt, dann können die beiden Schlitten mit einer Abstandseinrichtung miteinander gekoppelt sein, mit welcher der Abstand zwischen den beiden Haltearmen einstellbar ist. Eine solche Abstandseinrichtung kann beispielsweise eine Spindel sein, die an einem Schlitten in eine dort befestigte Spindelmutter eingreift und am anderen Schlitten mittels eines Motors drehbar gelagert ist. Durch Drehen der Spindel kann der Abstand zwischen den beiden Schlitten und damit der Abstand zwischen den beiden Haltearmen eingestellt werden.

Einer der Schlitten eines der Teilshuttle, der einen Haltearm trägt, kann mit einer Antriebseinrichtung zum Bewegen des Schlittens entlang der Shuttleschiene ausgebildet sein. Die Antriebseinrichtung kann beispielsweise ein Linearmotor sein.

Die Halteelemente zum Halten einer Leiterplatte sind vorzugsweise jeweils an einem Rand eines der Haltearme angeordnet, welche zum jeweils anderen Haltearm des gleichen Teilshuttles weisen.

Die Halteelemente können Klemmelemente sein, welche federbeaufschlagt sind, um eine steife Leiterplatte zwischen den Halteelementen der beiden Haltearme einzuklemmen.

Die Halteelemente können jedoch auch als Greifhalteelemente ausgebildet sein, welche den Rand einer Leiterplatte greifen. Derartige Greifhalteelemente werden vorzugsweise bei flexiblen Leiterplatten eingesetzt, so dass die von den Greifhalteelementen gegriffene Leiterplatte unter Spannung gesetzt wird, so dass die flexible Leiterplatte ebenflächig zwischen Haltearmen gespannt ist.

Die Prüfvorrichtung kann mit einer Be- und Entladeeinrichtung zum automatischen Be- und Entladen der Teilshuttle mit einer Leiterplatte im Aufnahmebereich vorgesehen sein. Die Verfahrstrecken der Teilshuttle sind vorzugsweise so lang ausgebildet, dass der Aufnahmebereich vom Prüfbereich derart unabhängig ist, dass ein Teilshuttle am Aufnahmebereich be- oder entladen werden kann und das andere Teilshuttle sich währenddessen am Prüfbereich zum Prüfen einer Leiterplatte befindet. Hierdurch ist es möglich, gleichzeitig einen Prüfvorgang auszuführen und eines der Teilshuttle zu be- und entladen und für einen weiteren Prüfvorgang vorzubereiten.

Im Aufnahmebereich kann unterhalb der Teilshuttle ein Aufnahmeelement angeordnet sein, um eine Leiterplatte aufzunehmen. Ein solches Aufnahmeelement kann beispielsweise als horizontale, ebenflächige Platte ausgebildet sein. Das Aufnahmeelement kann jedoch auch horizontal verlaufende Tragleisten aufweisen. Eine bereits getestete Leiterplatte kann von den Teilshuttlen auf das Aufnahmeelement fallengelassen werden, wobei eine weitere, zu testende Leiterplatte dem jeweiligen Teilshuttle oder beiden Teilshuttle dann mittels eines Greifarms von oben zugeführt werden kann. Das Teilshuttle oder die Teilshuttle werden mit der neu zugeführten Leiterplatte zum Prüfbereich bewegt, so dass die bereits getestete und auf dem Aufnahmeelement befindliche Leiterplatte mit dem Greifarm entfernt werden kann. Hierdurch kann die Unterbrechung zwischen zwei Prüfvorgängen zum Be- und Entladen eines oder beider Teilshuttle verkürzt werden.

Gleichermaßen ist es auch möglich eine bereits getestete erste Leiterplatte mittels des Greifarms vom Teilshuttle im Aufnahmebereich aufzunehmen und dem oder den Teilshuttle eine zweite, noch nicht getestete Leiterplatte mittels des Aufnahmeelementes in den oder die Teilshuttle einzusetzen.

Das Aufnahmeelement kann mehrere nach oben mündende Saugdüsen umfassen, welche in einer horizontalen Ebene verteilt angeordnet sind. Mit solchen Saugdüsen kann insbesondere eine flexible Leiterplatte gehalten werden, welche dann vorzugsweise mit Greifhalteelementen gegriffen wird. Die Saugdüsen können in zumindest zwei Leisten ausgebildet sein, welche vorzugsweise parallel zu den Führungsschienen ausgerichtet sind.

Vorzugsweise ist das Aufnahmeelement mit einer Hubeinrichtung versehen, so dass es in der Höhe einstellbar ist. Mit einem solchen Aufnahmeelement kann eine darauf abgelegte Leiterplatte auf das Niveau der Teilshuttle angehoben werden, so dass die Teilshuttle die Leiterplatte mit Greifhalteelementen greifen können.

Die Prüfvorrichtung kann eine Kamera aufweisen, um eine zu testende Leiterplatte, welche von einem Teilshuttle gehalten wird, abzutasten. Die Kamera kann verfahrbar an einer Führungsschiene angeordnet sein, an welcher auch ein oder mehrere Prüffinger verfahrbar angeordnet sind. Die Kamera kann auf einer Positioniereinrichtung angeordnet sein, welche einen Prüffinger hält. Es ist auch möglich, die Kamera stationär anzuordnen oder eine von der Führungsschiene unabhängige Schiene zum Bewegen der Kamera vorzusehen. Alternativ kann die Kamera auch in eine Be- und Entladeeinrichtung integriert sein.

Die Halteelemente an den Haltearmen können auch entlang der Haltearme verschiebbar ausgebildet sein. Ein Shuttle mit solchen Haltearmen stellt einen eigenständigen Erfindungsgedanken dar. Durch die Verschiebbarkeit der Halteelemente können diese so angeordnet sein, dass sie keine Leiterplattentestpunkte der Leiterplatte abdecken.

Nach einem weiteren Aspekt der vorliegenden Erfindung wird eine Prüfvorrichtung zum Testen von Leiterplatten, insbesondere zum Testen von unbestückten oder teilbestückten Leiterplatten vorgesehen. Die Prüfvorrichtung weist zumindest vier Prüffinger auf, die zum Kontaktieren von Leiterplattentestpunkten auf einer Seite einer zu testenden Leiterplatte vorgesehen sind. Die Prüffinger sind jeweils mit einer Prüfsonde versehen, wobei jeweils zwei der Prüffinger entlang einer Traversenschiene verfahrbar sind und die Prüffinger um eine zu einem Prüfbereich senkrecht stehende Achse drehbar sind, so dass sie mit ihren Prüfsonden in einem vorbestimmten Prüfbereich beliebige Punkte kontaktieren können. Die Prüffinger, die entlang einer gemeinsamen Führungsschiene verfahrbar sind, decken jeweils einen streifenförmigen Abtastbereich ab, wobei sich die beiden Abtastbereiche der zumindest zwei Paar Prüffinger etwas überlappen. Am Prüfbereich sind Halteelemente zum Halten einer zu testenden Leiterplatte vorgesehen. Diese Prüfvorrichtung zeichnet sich dadurch aus, dass die Halteelemente mit einer Verfahreinrichtung versehen sind, mit welcher sie zusammen mit einer von der Halteeinrichtung gehaltenen Leiterplatte in der Ebene des Prüfbereiches und quer zu den Führungsschienen verfahrbar sind.

Mit dieser Prüfvorrichtung können auch drei oder vier eng benachbarte Leiterplattentestpunkte, welche auf einer Linie liegen, die parallel zur Führungsschiene verläuft, zuverlässig gleichzeitig mit jeweils einem Prüffinger kontaktiert werden, da diese Leiterplattentestpunkte in dem sich überlappenden Bereich der beiden Abtastbereiche durch Verfahren der Leiterplatte angeordnet werden können. Eine solche Kontaktierung von drei oder mehreren Leiterplattentestpunkten ist zum Beispiel notwendig, wenn ein MOS-FET getestet werden soll. Weiterhin sind vier Leiterplattentestpunkte gleichzeitig zu kontaktieren, wenn eine Vier-Draht-Messung durchgeführt werden soll. Auch diese Leiterplattentestpunkte können entlang einer Linie angeordnet sein. Mit dieser Prüfvorrichtung können sie zuverlässig kontaktiert werden, selbst wenn die vier entlang einer Linie angeordneten Leiterplattentestpunkte sich parallel zur Führungsschiene erstrecken.

Die Führungsschienen sind vorzugsweise ortsfest angeordnet.

Die Führungsschienen können zueinander eng beabstandet angeordnet sein, so dass sie einen schmalen streifenförmigen Prüfbereich ausbilden, in dem eine hohe Dichte von Prüffingern angeordnet sind. Durch das Verfahren der Leiterplatte quer zu den Führungsschienen kann dann jeweils der zu prüfende Abschnitt in den Prüfbereich gebracht werden.

Die Verfahreinrichtung weist vorzugsweise eine Wegmesseinrichtung zum Messen des zurückgelegten Verfahrweges auf. Die Wegmesseinrichtung ist vorzugsweise mit einer Ortsauflösung von mindestens 10 µm oder weniger und insbesondere einer Ortsauflösung von mindestens 1 µm oder weniger bzw. mindestens 0,1 µm oder weniger ausgebildet.

Die Wegmesseinrichtung kann eine optische Skala und einen optischen Sensor aufweisen, die zueinander verfahrbar angeordnet sind, wobei der optische Sensor die Skala zum Erfassen des Verfahrweges abtastet.

Nach einem weiteren Aspekt der vorliegenden Erfindung betrifft die Erfindung ein Verfahren zum Prüfen einer Leiterplatte, wobei eine oben erläuterte Prüfvorrichtung mit zwei Teilshuttle verwendet wird. Eine zu testende Leiterplatte, welche sich in einem ersten Teilshuttle befindet, wird in einem ersten Testvorgang mittels der Prüffinger abgetastet und gleichzeitig wird das andere zweite Teilshuttle entladen, und mit einer weiteren zu testenden Leiterplatte beladen, wobei das zweite Teilshuttle zum Prüfbereich verfahren wird, damit dort die Leiterplatte mittels der Prüffinger in einem zweiten Testvorgang abgetastet wird, wenn der erste Testvorgang im Wesentlichen abgeschlossen ist.

Mit dieser Prüfvorrichtung können somit zwei Leiterplatten aufeinanderfolgend ohne Unterbrechung getestet werden. Es ist sogar möglich, die beiden Testvorgänge zeitlich etwas zu überlappen, wenn beispielsweise zum Testen der verbleibenden Leiterplattentestpunkte der ersten Leiterplatte nicht alle Prüffinger benötigt werden, kann mit den nicht benötigten Prüffingern bereits der zweite Testvorgang begonnen werden. Das bedeutet, dass ein Testvorgang im Wesentlichen abgeschlossen ist, wenn ein Großteil der abzutastenden Leiterplattentestpunkte bereits abgetastet ist, so dass nicht mehr alle Prüffinger zum Testen dieser Leiterplatte notwendig sind.

Die Leiterplatte im zweiten Teilshuttle kann mittels einer Kamera erfasst werden, bevor sie der Abtastung durch die Prüffinger unterzogen wird. Bei einer solchen optischen Erfassung mittels einer Kamera kann die Position der Leiterplatte bezüglich des zweiten Teilshuttles bestimmt werden.

Bei einem weiteren Verfahren zum Prüfen einer Leiterplatte wird eine oben erläuterte Prüfvorrichtung verwendet, welche ein Aufnahmeelement unterhalb des Shuttles bzw. der Teilshuttle aufweist. Nach Beendigung eines Testvorganges wird eine Leiterplatte mittels des Shuttles bzw. der Teilshuttle zum Aufnahmebereich verfahren, dort auf das Aufnahmeelement fallen gelassen und eine weitere zweite Leiterplatte wird von oben in den Haltebereich des Shuttles bzw. eines oder beider Teilshuttle eingesetzt. Die zweite Leiterplatte kann dann zum Prüfbereich verfahren werden, wodurch die erste sich auf dem Aufnahmeelement befindliche Leiterplatte frei zugänglich wird und vom Aufnahmeelement abgehoben und außerhalb des Aufnahme- und Prüfbereichs abgelegt werden kann.

Gleichermaßen ist es auch möglich eine bereits getestete erste Leiterplatte mittels des Greifarms vom Teilshuttle im Aufnahmebereich aufzunehmen und dem oder den Teilshuttle eine zweite, noch nicht getestete Leiterplatte mittels des Aufnahmeelementes in den oder die Teilshuttle einzusetzen. Beim Einsetzen der zu testenden Leiterplatte wird das Aufnahmeelement, dem zuvor bereits mittels des Greifarms eine zu testende Leiterplatte zugeführt worden ist, angehoben, bis sich die Leiterplatte auf Höhe des oder der Teilshuttle befindet. Das oder die Teilshuttle können dann die Leiterplatte fixieren bzw. greifen. Das Aufnahmeelement wird danach wieder abgesenkt, so dass das oder die Teilshuttle mit der zu testenden Leiterplatte frei verfahren werden können.

Dieses Verfahren kann sowohl mit einer Prüfvorrichtung mit zwei Teilshuttle als auch mit einer Prüfvorrichtung mit lediglich einem einzigen Shuttle ausgeführt werden. Dadurch, dass mit dem Aufnahmeelement und dem Greifarm zwei Leiterplatten an den Teilshuttle sehr schnell ausgetauscht werden können, kann der Durchsatz der Prüfvorrichtung gesteigert werden.

Gemäß einem weiteren Aspekt der vorliegenden Erfindung wird bei einem Verfahren zum Prüfen einer Leiterplatte eine oben erläuterte Prüfvorrichtung verwendet, welche zumindest vier Prüffinger aufweist, die zum Kontaktieren von Leiterplattentestpunkten auf einer Seite einer zu testenden Leiterplatte vorgesehen sind, wobei jeweils zwei der Prüffinger entlang einer Führungsschiene verfahrbar sind und die Prüffinger um eine zu einem Prüfbereich senkrecht stehende Achse drehbar sind, so dass sie mit den Prüfsonden in einem vorbestimmten Prüfbereich beliebige Punkte kontaktieren können, wobei die Prüffinger, die entlang einer gemeinsamen Führungsschiene verfahrbar sind, jeweils einen streifenförmigen Abtastbereich abdecken und sich die beiden Abtastbereiche der zumindest zwei Paar Prüffinger etwas überlappen und Halteelemente zum Halten einer zu testenden Leiterplatte vorgesehen sind, welche mittels einer Verfahreinrichtung quer zu den Führungsschienen verfahrbar sind. Bei diesem Verfahren wird eine zu testende Leiterplatte während eines Testvorganges ein- oder mehrfach quer zu den Führungsschienen bewegt, um die Bewegungen der Prüffinger zu minimieren. Als Testvorgang wird der Vorgang zwischen dem erstmaligen und letztmaligen Kontaktieren der zu testenden Leiterplatte mittels einer der Prüffinger bezeichnet. Die Leiterplatte wird vorzugsweise in vielen kleinen Schritten derart bewegt, dass die Drehbewegungen der Prüffinger möglichst klein gehalten werden, um in möglichst schneller Abfolge viele Leiterplattentestpunkte kontaktieren zu können.

Vorzugsweise werden Abschnitte der Leiterplatte, welche eine hohe Dichte bzw. hohe Anzahl von noch zu testenden Leiterplattentestpunkten aufweisen, in Bereiche gebracht, in welchen sich die Abtastbereiche der Prüffinger überlappen. In den überlappenden Abschnitten der Abtastbereiche können die Leiterplattentestpunkte schnell mit vielen Prüffingern abgetastet werden. Die Abschnitte der Leiterplatte, welche eine hohe Dichte bzw. hohe Anzahl von noch zu testenden Leiterplattentestpunkten aufweisen, verändert sich mit fortschreitendem Testvorgang, da bereits abgetastete Leiterplattentestpunkte, die nicht mehr abgetastet werden, hierbei nicht zu berücksichtigen sind.

Bei bestimmten Messungen sind drei oder vier Leiterplattentestpunkte gleichzeitig zu kontaktieren. Diese Leiterplattentestpunkte sind oftmals eng benachbart zueinander angeordnet, so dass diese Leiterplattentestpunkte nicht gleichzeitig kontaktiert werden können, wenn sie sich in einem Bereich befinden, der nur von zwei Prüffingern erfasst wird. Solche Messungen sind beispielsweise bei Vier-Draht-Messungen oder beim Testen der Anschlüsse eines MOS-FETs notwendig. Die Leiterplatte wird daher vorzugsweise so positioniert, dass zum Ausführen dieser Messung die Leiterplattentestpunkte sich in den überlappenden Abschnitten der Abtastbereiche befinden, so dass drei oder vier Leiterplattentestpunkte gleichzeitig mit drei oder vier Prüffingern kontaktierbar sind. Die Leiterplatte wird so bewegt, dass die einzelnen Gruppen von drei oder vier gleichzeitig zu kontaktierenden Leiterplattentestpunkten in diesen Abschnitten angeordnet werden.

Bei diesem Verfahren wird zwischen den einzelnen Bewegungen der Leiterplatte mittels der Teilshuttle keine Kalibrierung ausgeführt. Vorzugsweise wird das Shuttle oder werden die Teilshuttle vorab einmal in unterschiedlichen Positionen bzgl. der Traversen kalibriert. Die Erfinder haben erkannt, dass im Gegensatz zu herkömmlichen Fingertestern (z.B. WO 2006/133808 A1), bei welchen die zu testenden Leiterplatten auch bzgl. der Traversen bewegt werden können, es möglich ist, den Bewegungsmechanismus so präzise auszubilden, dass nicht nach jeder Bewegung der Shuttle bzw. der zu testenden Leiterplatte eine erneute Kalibrierung notwendig ist. bei der Kalibrierung wird vorzugsweise eine Kalibrierplatte mit einer Vielzahl eindeutig identifizierbarer Marken in das oder die Shuttle eingelegt und es werden mit der Kamera unterschiedliche Positionen der Kalibrierplatte und damit des oder der Shuttle erfasst und mit den von der Wegmesseinrichtung erfassten Wegdaten korreliert. So kann dann später anhand der erfassten Wegdaten immer der aktuelle Ort der zu testenden Leiterplatte bzgl. der Traversen mit der zum Kontaktieren der Leiterplattentestpunkte nötigen Präzision zur Verfügung gestellt werden, ohne dass eine weitere Kalibrierung notwendig ist.

Die Erfindung wird nachfolgend anhand der in der Zeichnung dargestellten Ausführungsbeispiele beispielhaft näher erläutert. Die Zeichnungen zeigen in:
- Figur 1: eine Traverseneinheit für die Prüfvorrichtung zum Testen von Leiterplatten in einer perspektivischen Ansicht,
- Figur 2: zwei Traverseneinheiten für eine Prüfvorrichtung zum Testen von Leiterplatten in einer perspektivischen Ansicht,
- Figur 3: die Traverseneinheiten aus Figur 2 in einer Ansicht von vorne,
- Figur 4: die Traverseneinheiten aus Figur 2 und 3 in einer Schnittansicht,
- Figur 5: eine Prüfvorrichtung zum Prüfen von Leiterplatten mit zwei Teilshuttle und einer Be- und Entladeeinrichtung in einer Draufsicht,
- Figur 6: ein Teilshuttle aus Figur 5 in einer Draufsicht zusammen mit einer Shuttleschiene,
- Figur 7A, 7B: eine Halteeinrichtung mit mehreren Halteelementen in der Draufsicht und einer Seitenansicht im Greifzustand,
- Figur 8A, 8B: die Halteeinrichtung mit den Halteelementen aus Figur 7A, 7B in einem Aufnahmezustand,
- Figur 9A, 9B: ein Aufnahmeelement in Form eines Hubtisches in einer Seitenansicht und einer Draufsicht in abgesenkter Position, und
- Figur 10: den Hubtisch aus Figur 9A, 9B in angehobener Position.

Eine erfindungsgemäße Prüfvorrichtung 1 zum Testen von Leiterplatten 2 weist eine Traverseneinheit 3, entlang welcher mehrere Prüffinger 4 verfahrbar sind, zumindest ein Shuttle, das im vorliegenden Ausführungsbeispiel aus zwei Teilshuttle 5, 6 ausgebildet ist, mit welchen die zu testenden Leiterplatten von einem Aufnahmebereich 7 zu einem Prüfbereich 8 und wieder zurück verfahrbar sind.

Die Prüfvorrichtung 1 weist eine Be- und Entladeeinrichtung 9 auf, mit welcher Leiterplatten 2 von einem Vorratsstapel 10 zum Aufnahmebereich 7 und vom Aufnahmebereich 7 zu zwei Ablagestapel 11, 12 befördert werden können.

Die Be- und Entladeeinrichtung 9 weist eine Transportschiene 13 auf, welche sich entlang des Vorratsstapels 10, des Aufnahmebereichs 7 und der Ablagestapel 11, 12 erstreckt. An der Transportschiene 13 ist ein Transportschlitten 14 verfahrbar angeordnet, welcher mit einem Greifarm 15 eine Leiterplatte greifen kann. Im vorliegenden Ausführungsbeispiel sind am Greifarm 15 Saugnäpfe 16 vorgesehen, mit welchen eine Leiterplatte 2 von oben gefasst, bewegt und wieder abgelegt werden kann.

Die Stapel 10, 11, 12 von Leiterplatten 2 sind jeweils mit der untersten Leiterplatte auf einer Hubeinrichtung 17 angeordnet, welche den jeweiligen Stapel 10, 11, 12 derart anheben kann, dass sich die oberste Leiterplatte in einem Hubbereich der Greifarme 15 des Transportschlittens 14 befindet.

Die Teilshuttle 5, 6 sind jeweils aus zwei Haltearmen 18, 19, 20, 21 ausgebildet, welche jeweils an einem Schlitten 22, 23, 24, 25 befestigt sind. Die Schlitten 22, 23 bzw. 24, 25 jeweils eines der Teilshuttle 5, 6 sind jeweils verschieblich auf einer Shuttleschieneneinrichtung 26, 27 angeordnet. Die beiden Shuttleschieneneinrichtungen 26, 27 bestehen jeweils aus zwei parallel verlaufende Shuttleschienen 28, so dass die Schlitten einerseits entlang der Schienen 28 verfahrbar geführt sind und andererseits gegen ein Verkippen um die Längsrichtung der Shuttleschienen 28 gesichert sind. Die Haltearme 18-21 erstrecken sich jeweils horizontal von den Schlitten 22-25. Die Haltearme 18-21 sind jeweils parallel zur Traverseneinheit 3 bzw. quer zur Längsrichtung der Shuttleschienen 28 bzw. zur Bewegungsrichtung 57 der Teilshuttle 5, 6 angeordnet. Die Shuttleschieneneinrichtungen 26, 27 erstrecken sich entlang der seitlichen Ränder des Aufnahmebereichs 7 und des Prüfbereichs 8, wobei die Haltearme sich von den Schlitten 22-25 in den Innenbereich zwischen den beiden Shuttleschieneneinrichtungen 26, 27 erstrecken. Die Shuttleschieneneinrichtungen definieren somit für die jeweiligen Teilshuttle 5, 6 eine Verfahrstrecke in Bewegungsrichtung 57, welche parallel und nebeneinander angeordnet sind.

Die von den Schlitten 22-25 entfernten, freien Enden der Haltearme 18-21 erstrecken sich etwa bis zu einer Mittellinie 29 zwischen den beiden Schlitteneinrichtungen 26, 27, wobei die freien Enden der Haltearme 18-21 geringfügig von den freien Enden der Haltearme des jeweils anderen Teilshuttles beabstandet sind, auch wenn sie sich an der gleichen Position entlang der jeweiligen Shuttleschieneneinrichtung 26, 27 befinden. Hierdurch ist sichergestellt, dass die beiden Teilshuttle 5, 6 aneinander vorbeigefahren werden können.

Die Haltearme 18-21 weisen jeweils eine Halteeinrichtung 30 auf, an welcher Halteelemente 31 zum Halten einer Leiterplatte angeordnet sind. Die Halteeinrichtungen 30 und die Halteelemente 31 sind jeweils am Rand der Haltearme 18-21 angeordnet, welcher zum anderen Haltearm des gleichen Teilshuttles 5, 6 weist.

Die Halteeinrichtungen 30 sind jeweils mittels zweier Scharniergelenke 32 an den Haltearmen 18-21 befestigt. Die Halteeinrichtungen 30 können nach oben geklappt werden und in nach oben geklapptem Zustand axial bezüglich der Haltearme 18-21 verschoben werden, wodurch die Scharniergelenke 32 gelöst werden. Hierdurch können die Halteeinrichtungen 30 durch andere Halteeinrichtungen ausgetauscht werden.

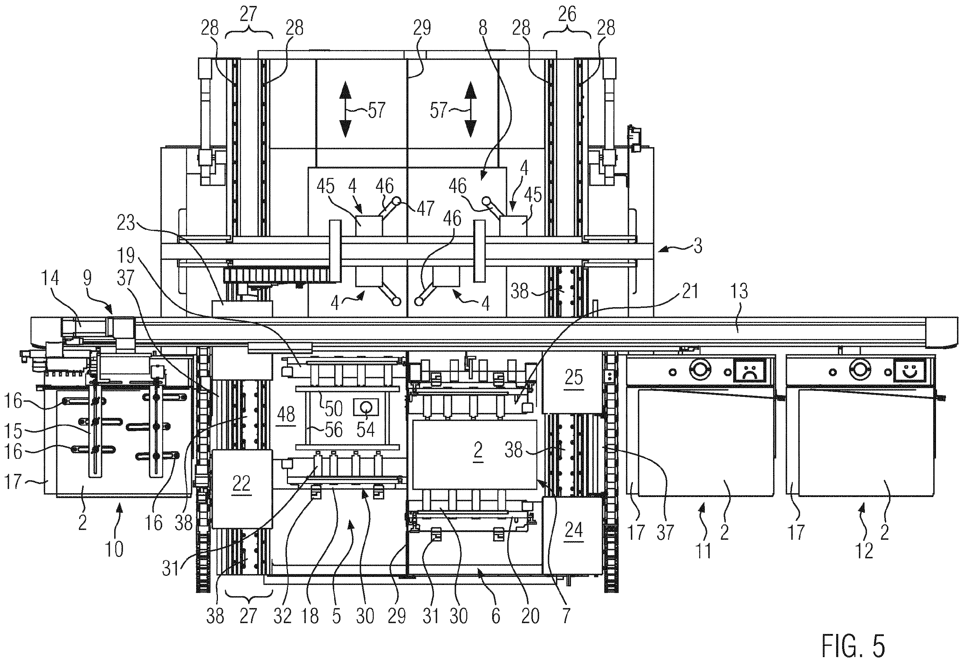

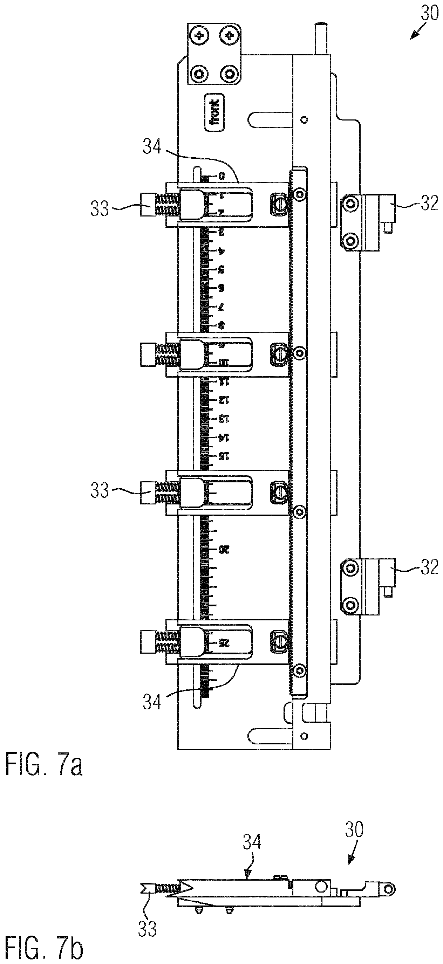

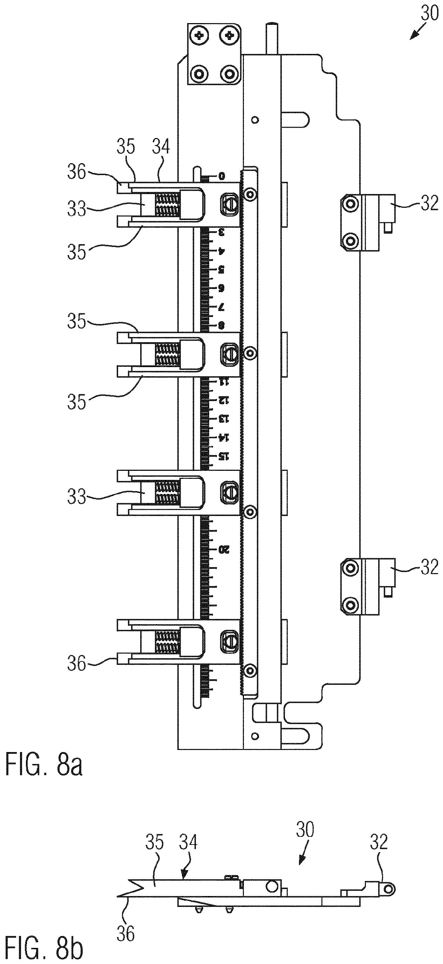

Die in den Figuren 5 - 8b gezeigten Halteeinrichtungen 30 sind zum Halten von steifen Leiterplatten vorgesehen. Die Halteelemente 31 weisen jeweils einen horizontal gekerbten Klemmbacken 33 auf (Figur 7a, 7b). Die Klemmbacken 33 sind jeweils von einer Aufnahmegabel 34 umschlossen, welche jeweils zwei zum anderen Haltearm 18-21 des gleichen Teilshuttles 5, 6 weisende Zinken 35 besitzt. Die Zinken 35 sind wiederum horizontal eingekerbt (Figur 8a, 8b), wobei sie an ihrer Unterseite einen nach vorne vorspringenden Vorsprung 36 aufweisen. Zum Aufnehmen einer Leiterplatte werden die Klemmbacken 33 in den Bereich zwischen den beiden Zinken 35 der jeweiligen Aufnahmegabel 34 eingezogen (Figur 8a, 8b), so dass die Zinken 35 seitlich an den Klemmbacken 33 ein Stück vorstehen. Eine Leiterplatte 2 kann dann auf die Vorsprünge 36 der Zinken 35 aufgelegt werden und durch Zusammenfahren der Haltearme 18-21 bzw. 20, 21 und Zurücknehmen der Aufnahmegabeln 34 zwischen den Klemmbacken 33 eingeklemmt werden. Die Halteeinrichtungen 30 weisen ein Stellelement (nicht dargestellt) auf, mit welchem die Aufnahmegabeln 34 bezüglich der Klemmbacken 33 gemeinsam zwischen den beiden in Figur 7a, 7b bzw. in Figur 8a, 8b gezeigten Positionen verschoben werden können.

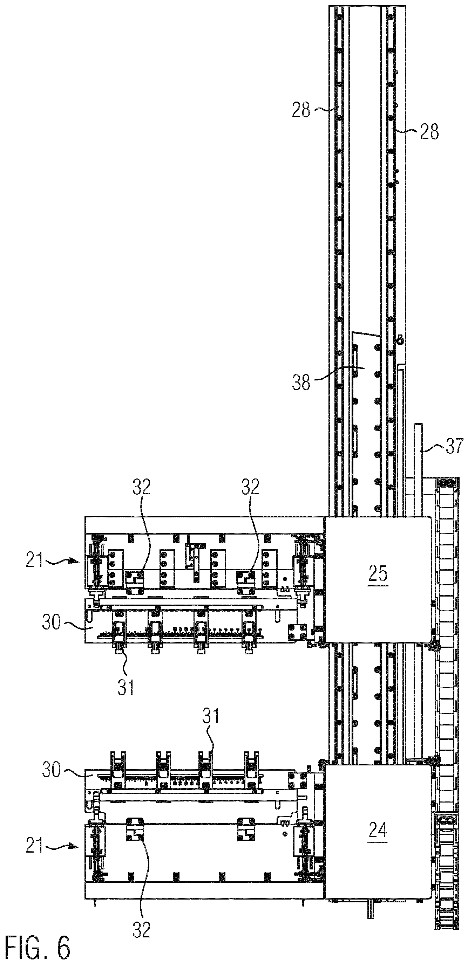

Die beiden Schlitten 22, 23 bzw. 24, 25 jeweils eines der Teilshuttle 5, 6 sind mit einer Abstandseinrichtung miteinander gekoppelt, mit welcher der Abstand zwischen den beiden Schlitten 22, 23 bzw. 24, 25 bzw. den entsprechenden Haltearmen 18, 19 bzw. 20, 21 einstellbar ist. Im vorliegenden Ausführungsbeispiel umfasst die Abstandseinrichtung eine Gewindespindel 37 (Figur 5, 6), welche an den Schlitten 22, 24 jeweils drehbar mittels eines Motors (nicht dargestellt) gelagert ist und an dem anderen Schlitten 23, 25 jeweils eine drehfest angeordnete Spindelmutter (nicht dargestellt) durchgreift. Durch Drehen der Gewindespindel 37 mittels des jeweiligen Motors wird somit der Abstand der entsprechenden Schlitten bzw. Haltearme verstellt.

Die Schlitten 22, 24 weisen jeweils eine Antriebseinrichtung zum Bewegen der jeweiligen Teilshuttle 5, 6 entlang der Schlittenschieneneinrichtungen 26, 27 auf. Im vorliegenden Ausführungsbeispiel sind die Antriebseinrichtungen als Linearmotoren ausgebildet, wobei in den Shuttleschieneneinrichtungen 26, 27 im Bereich zwischen den Shuttleschienen 28 Magnetelemente 38 angeordnet sind, welche den Stator des Linearmotors bilden. Im Rahmen der Erfindung können selbstverständlich auch andere Antriebseinrichtungen, wie zum Beispiel Reibräder oder Zahnräder zum Antreiben der Teilshuttle 5, 6 entlang der Shuttleschieneneinrichtungen 26, 27 vorgesehen sein.

Die Teilshuttle 5, 6 weisen eine Wegmesseinrichtung (nicht dargestellt) auf, mit welcher der Verfahrweg entlang der Schlittenschieneneinrichtungen 26, 27 gemessen wird. Im vorliegenden Ausführungsbeispiel ist die Wegmesseinrichtung mittels einer optischen Skala, welche an den Shuttleschieneneinrichtungen 26, 27 angeordnet ist, und einem optischen Sensor, welcher jeweils an einem Schlitten der beiden Teilshuttle 5, 6 angeordnet ist und die Skala abtastet, ausgebildet. Mit einer solchen Wegmesseinrichtung kann eine Ortsauflösung von 10 µm oder weniger erzielt werden. Die Wegmesseinrichtung ist mit einer zentralen Steuereinrichtung (nicht dargestellt) verbunden.

Der Bereich zwischen den Shuttleschieneneinrichtungen 26, 27 bildet einen Arbeitsbereich, in dem Leiterplatten 2 angeordnet und mittels der Teilshuttle 5, 6 in Bewegungsrichtung 57 entlang zweier parallel und nebeneinander verlaufender Verfahrstrecken hin und her verfahren werden können. Die Seite des Arbeitsbereiches, an dem der Aufnahmebereich 7 angeordnet ist, wird als Vorderseite des Arbeitsbereiches bzw. der Prüfvorrichtung 1 und die Seite, an welcher der Prüfbereich 8 angeordnet ist, als Rückseite oder hintere Seite bezeichnet. Dementsprechend werden im Folgenden auch die Begriffe "nach vorne" als zur Vorderseite gerichtet und "nach hinten" als zur Rückseite gerichtet, verwendet.

Im vorliegenden Ausführungsbeispiel greifen die Antriebseinrichtungen jeweils an den vorderen Schlitten 22, 24 an. An den vorderen Schlitten 22, 24 ist auch jeweils der Motor zum Drehen der Gewindespindel 37 angeordnet. Diese Antriebseinrichtungen bzw. die Motoren könnten gleichermaßen an den hinteren Schlitten 23, 25 angeordnet sein.

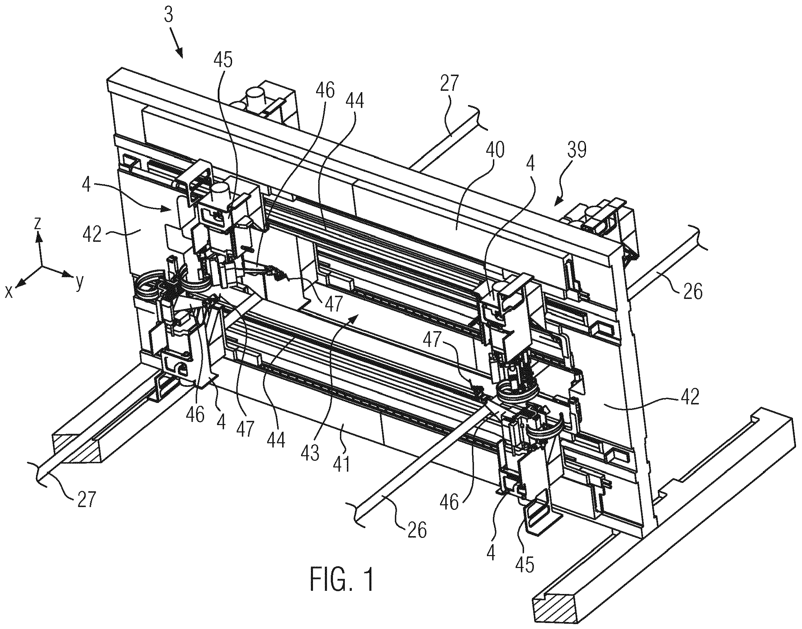

Die Traverseneinheit 3 weist einen Rahmen 39 auf, der einen oberen Querbalken 40 und einen unteren Querbalken 41 und zwei vertikale seitliche Balken 42 aufweist (Fig. 1). Die Balken 40, 41, 42 umschließen eine Durchgangsöffnung 43. Die Balken 40, 41, 42 sind aus plattenförmigen Elementen ausgebildet, so dass der Rahmen 39 einen plattenförmigen Körper mit einer Durchgangsöffnung 43 bildet.

Am oberen und unteren Querbalken 40, 41 sind jeweils an der Vorder- als auch an der Rückseite horizontal verlaufende Führungsschienen 44 angeordnet, an welchen jeweils zwei Prüffinger 4 entlang der Führungsschienen 44 verfahrbar gelagert sind. Die Prüffinger 4 sind jeweils aus einem Positionierelement 45, das an den Führungsschienen 44 gelagert ist, einem Testfinger 46, der um eine vertikale Achse schwenkbar am Positionierelement 45 gelagert ist und aus einer Prüfsonde 47 ausgebildet, welche jeweils in einem der freien Enden der Testfinger 46 angeordnet ist. Mit den Prüfsonden 47 werden Leiterplattentestpunkte einer zu testenden Leiterplatte kontaktiert. Die Prüfsonden sind beispielsweise als federbeaufschlagte Kontaktstifte ausgebildet.

Die Positionierelemente 45 werden mittels Linearmotoren entlang der Führungsschienen 44 verfahren.

An den seitlichen Rändern der Durchgangsöffnung 43 erstrecken sich die Shuttleschieneneinrichtungen 26, 27, wobei die Shuttleschieneneinrichtungen 26, 27 senkrecht zur Ebene des plattenförmigen Rahmens 39 angeordnet sind. Die Teilshuttle 5, 6 können dann im Bereich der Durchgangsöffnung 43 derart positioniert werden, dass sie bzw. eine von ihnen gehaltene Leiterplatte 2 sich zwischen den oberen Prüffingern, welche am oberen Querbalken 40 verschieblich gelagert sind, und den unteren Prüffingern, welche am unteren Querbalken 41 verschieblich gelagert sind, angeordnet sind. Die oberen Prüffinger 4 und die unteren Prüffinger 4 können jeweils mit ihren Prüfsonden 47 oben bzw. unten die von den Teilshuttlen 5, 6 gehaltene Leiterplatte kontaktieren.

Die beiden Prüffinger 4, die jeweils auf einer Führungsschiene 44 angeordnet sind, decken einen streifenförmigen Abtastbereich ab, in dem sie jeden beliebigen Punkt mit ihren Prüfsonden 47 kontaktieren können. Diese streifenförmigen Abtastbereiche verlaufen parallel zur Ebene des Rahmens 39 bzw. zu den Führungsschienen 44. Die Abtastbereiche der Prüffinger auf der Vorderseite des Rahmens 39 und auf der Rückseite des Rahmens 39 überlappen sich etwas. In dem überlappenden Abschnitt können Leiterplattentestpunkte sowohl von Prüffingern der Vorder- als auch von Prüffingern der Rückseite kontaktiert werden. Dies gilt gleichermaßen für die oberen Prüffinger als auch für die unteren Prüffinger.

Bei dem Ausführungsbeispiel gemäß Figur 1 und Figur 5 ist eine einzige Traverseneinheit 3 vorgesehen, welche auf der Vorder- und Rückseite jeweils am oberen Querbalken 40 und am unteren Querbalken 41 eine Führungsschiene 44 mit jeweils zwei Prüffingern 4 aufweist. Insgesamt sind somit acht Prüffinger an der Traverseneinheit 3 angeordnet.

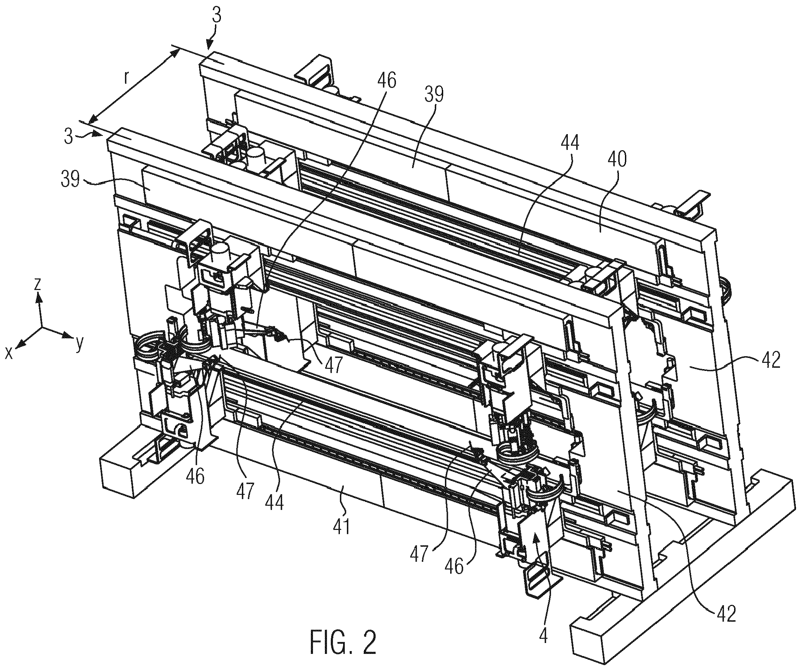

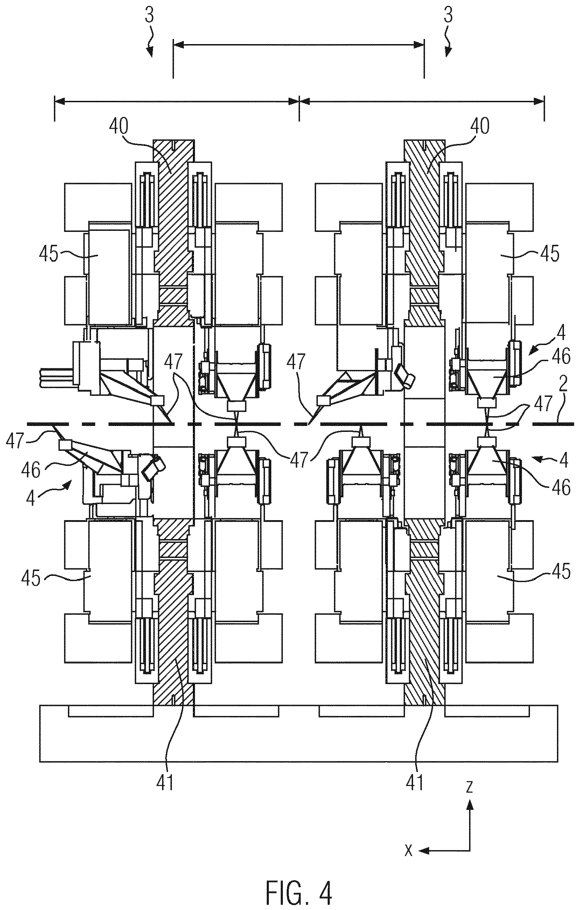

Die Prüfvorrichtung 1 kann auch mit mehr als einer Traverseneinheit, wie zum Beispiel zwei oder drei Traverseneinheiten ausgebildet sein. Die Figuren 2-4 zeigen jeweils eine Anordnung mit zwei Traverseneinheiten.

Der Aufbau dieser Traverseneinheiten entspricht im Wesentlichen dem Aufbau der Traverseneinheiten, wie sie in der internationalen Patentanmeldung WO 2014/140029 A1 beschrieben sind, auf welche hier vollinhaltlich Bezug genommen wird. Eine solche Traverseneinheit 3 zeichnet sich dadurch aus, dass zumindest zwei voneinander unabhängige Linearführungen bzw. Führungsschienen 44 zum Führen jeweils zumindest eines Prüffingers 4 vorgesehen sind.

Diese Prüfvorrichtung 1 unterscheidet sich von herkömmlichen Prüfvorrichtungen dadurch, dass während eines Testvorganges, während dem die Leiterplattentestpunkte aufeinander folgend mit den Prüffingern 4 abgetastet werden, die zu testende Leiterplatte mittels der Teilshuttle 5, 6 quer zu der bzw. zu den Traverseneinheiten bewegt wird. Da die Position der Teilshuttle 5, 6 und damit die Position der Leiterplatten in Bewegungsrichtung der Teilshuttle durch die Wegmesseinrichtung sehr präzise erfasst wird, erfolgt während der Testvorgänge ein Großteil der relativen Bewegungen zwischen der Leiterplatte und den Prüfsonden durch Verfahren der Teilshuttle. Bei herkömmlichen Prüfvorrichtungen ist es üblich, dass die Leiterplatte in einer bestimmten Position in der Prüfvorrichtung angeordnet, kalibriert wird und dann werden alleine die Prüffinger bewegt. Die Prüffinger können bewegt werden, indem sie entlang einer Traverse verfahren werden und indem sie um eine vertikale Achse gedreht werden, wobei bei solchen herkömmlichen Prüfvorrichtungen mehrere Traversen vorgesehen sind, um einen vorbestimmten Prüfbereich vollständig abzudecken. Es gibt auch herkömmliche Prüfvorrichtungen, bei welchen die Traversen selbst bewegt werden. Bei der vorliegenden Prüfvorrichtung 1 ist es aufgrund der präzisen Wegmesseinrichtung nicht notwendig, eine Leiterplatte nach jeder Bewegung eines der Teilshuttle 5, 6 neu zu kalibrieren. Es genügt eine Kalibrierung zu Beginn des Testvorganges und die Leiterplatte kann dann während des Testvorganges beliebig oft mittels der Teilshuttle bewegt werden. Hierdurch wird ein weiterer Freiheitsgrad neben der Bewegung der Prüffinger entlang Führungsschienen der Traverseneinheiten und dem Drehen der Prüffinger erhalten.

Da die Teilshuttle 5, 6 und nicht die Traverseneinheiten bewegt werden, können die Traverseneinheiten aus einem massiven und stabilen Stahlkörper ausgebildet sein, an dem Prüffinger mit langen Testfingern angeordnet sind. Da die Traverseneinheiten ortsfest sind, gibt es keine grundsätzlichen Beschränkungen des Gewichtes der Traverseneinheiten. Sie sind daher sehr stabil und können die Prüffinger sehr präzise führen. Dies erlaubt die Verwendung langer Testfinger, mit welchen ein wesentlich größerer Prüfbereich als mit kurzen Testfingern abgedeckt wird. Die Testfinger haben eine Länge von zumindest 5 cm, welche als Abstand zwischen einer Spitze der Prüfsonde und der Rotationsachse des jeweiligen Prüffingers gemessen wird. Die Länge der Testfinger kann auch größer sein und beispielsweise zumindest 7 cm oder zumindest 9 cm betragen.

Dieses Prinzip des Verfahrens der Leiterplatte mittels der Shuttle während des Testens derselben bezüglich der Traverseneinheiten erlaubt es, wenn mehrere Traverseneinheiten vorgesehen sind, diese dicht aneinander anzuordnen, so dass ein Prüfbereich mit einer hohen Dichte von Prüffingern vorgesehen wird. Der maximale Abstand der Traverseneinheiten beträgt nicht mehr als 600 mm, insbesondere nicht mehr als 500 mm bzw. nicht mehr als 350 mm und besonders bevorzugt nicht mehr als 250 mm. Der minimale Abstand der Traversen beträgt vorzugsweise zumindest 80 mm, vorzugsweise zumindest 100 mm und insbesondere zumindest 200 mm. Die Armlänge eines Testfingers beträgt zumindest 60%, vorzugsweise zumindest 70 % und insbesondere zumindest 75% des Abstandes zwischen zwei benachbarten Traversen. Die Armlänge ist der Abstand einer Kontaktspitze der Prüfsonde des Testfingers von der Rotationsachse des Testfingers.

Hierdurch können Leiterplatten mit einer hohen Dichte von Leiterplattentestpunkten sehr schnell abgetastet werden. Eine eng benachbarte Anordnung der einzelnen Traverseneinheiten führt zwar zu einem kleinen Prüfbereich im Vergleich zu einer Prüfvorrichtung, in welcher die Traverseneinheiten weiter beabstandet sind, jedoch ist dies bei der vorliegenden Prüfvorrichtung kein Nachteil, da während des Testvorganges die Leiterplatte mittels der Shuttle verfahren und neu bezüglich der Traverseneinheiten positioniert werden kann. So können auch Bereiche der Leiterplatten geprüft werden, die zunächst außerhalb des Prüfbereichs der Prüffinger lagen.

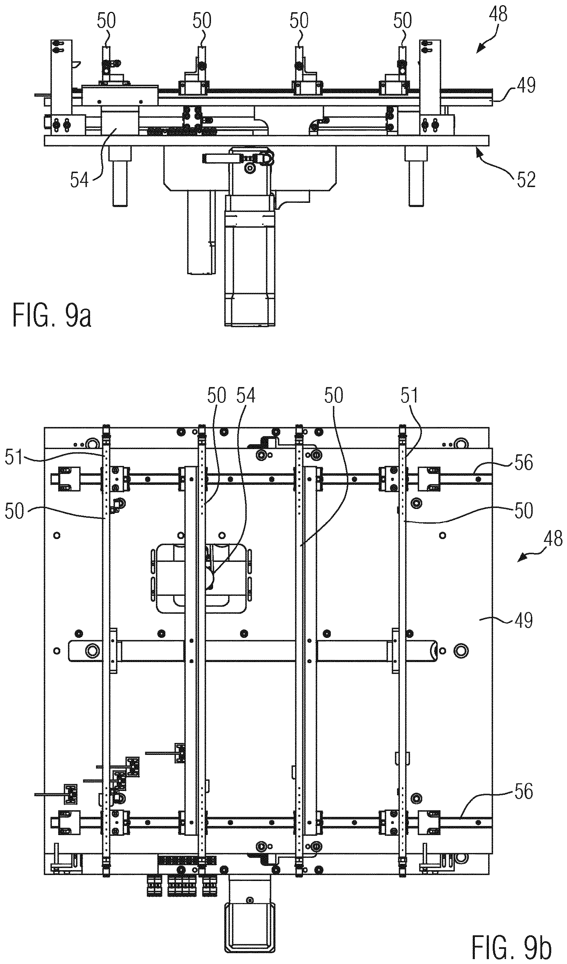

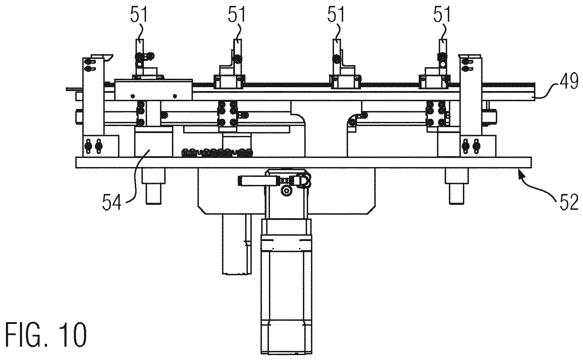

Im Aufnahmebereich 7 sind zwei Hubtische 48 (Figur 9A-10) angeordnet, welche jeweils einem der beiden Teilshuttle 5, 6 zugeordnet sind. Die Hubtische besitzen eine horizontal angeordnete Hubplatte 49, auf welcher mehrere Saugleisten 50 mit nach oben mündenden Sauglöchern bzw. Saugdüsen 51 angeordnet sind. Die Saugleisten 50 sind quer zur Bewegungsrichtung der Teilshuttle 5, 6 angeordnet.

Die Hubplatte 49 wird von unten von einem Gestell 52 unterstützt, das einen elektrisch angetriebenen Hubzylinder 53 zum Anheben und Absenken der Hubplatte 49 aufweist. Am Gestellt 52 ist eine Kamera 54 befestigt, welche mit Blickrichtung nach oben angeordnet ist. Im Bereich der Kamera 54 weist die Hubplatte 49 eine Ausnehmung 55 auf.

Die Saugleisten 50 sind entlang von quer zu den Saugleisten 50 verlaufenden Schienen 56 verstellbar. Hierzu ist eine Verstelleinrichtung (nicht dargestellt) vorgesehen, welche ein Transportband aufweist, das selektiv an einzelne Saugleisten 50 koppelbar ist, so dass durch eine Kopplung an das Transportband und eine Bewegung des Transportbandes eine oder mehrere Saugleisten 50 in ihrer Position verändert werden können. Die Saugleisten 50 sind an eine Unterdruckpumpe angeschlossen, so dass durch die Sauglöcher 51 Luft angesaugt werden kann.

Diese Hubtische 48 fungieren als Aufnahmeelemente zum Aufnehmen von Leiterplatten. Sie können als kurzzeitiger Zwischenspeicher einer einzelnen Leiterplatte verwendet werden, wie es unten näher erläutert wird. Aufgrund der Saugleisten 50 sind sie besonders geeignet, flexible Leiterplatten aufzunehmen, mittels der Sauglöcher 51 zu fixieren und durch Anheben der Hubplatte 49 so zu positionieren, dass die flexible Leiterplatte an ihrem Randbereich von entsprechenden Greifelementen, die an den Haltearmen 18-21 zum Halten von flexiblen Leiterplatten vorgesehen werden können, anzuordnen. Die Ränder der flexiblen Leiterplatten, die über die Saugleisten 50 hinausstehen, können dann von diesen Greifelementen gegriffen werden. Dadurch, dass die Saugleisten in ihrem Abstand zueinander verstellbar sind, können sie zum Aufnehmen unterschiedlich großer Leiterplatten eingestellt werden.

Nachfolgend wird der Betrieb der Prüfvorrichtung zum Prüfen von Leiterplatten mit einer maximalen Größe, die in den Haltebereich eines einzelnen der Teilshuttle 5, 6 passt, erläutert.

Zunächst wird eine erste Leiterplatte vom Vorratsstapel 10 mittels des Greifarms 15 der Be- und Entladeeinrichtung 9 abgehoben und zum Aufnahmebereich 7 über eines der Teilshuttle 5 verfahren.

Das Teilshuttle 5 wird unterhalb der Leiterplatte 2 so positioniert, dass die Halteeinrichtungen 30 der Haltearme 18, 19 in etwa mit den entsprechenden Rändern der Leiterplatte 2 fluchten, wobei der Abstand der beiden Haltearme 18, 19 mittels der Abstandseinrichtung so eingestellt wird, dass die Vorsprünge 36 der Zinken 35, welche an den Klemmbacken 33 vorstehen (gemäß Figur 8a, 8b) geringfügig weniger beabstandet sind, als die Breite auf der Leiterplatte 2 ist. Die Leiterplatte 2 wird dann auf die Vorsprünge 36 der Zinken 35 mittels des Greifarms 15 abgelegt, wobei der Greifarm dann seine Saugnäpfe 16 löst und zurück zum Vorratsstapel 10 bewegt wird.

Die Leiterplatte 2 liegt zunächst lose auf den Vorsprüngen 36 der Zinken 35 der Aufnahmegabeln 34. Die Haltearme 18, 19 werden mit der Abstandseinrichtung ein Stück zusammengefahren, so dass die Klemmbacken 33 gegen die Ränder der Leiterplatte 2 gedrückt werden. Die Aufnahmegabeln 34 werden bezüglich der Klemmbacken 33 zurückgezogen. Die Leiterplatte 2 ist somit zwischen den beiden Haltearmen 18, 19 fest eingespannt und das Teilshuttle 5 kann mit der Leiterplatte 2 entlang der Shuttleschieneneinrichtung 26 in Bewegungsrichtung 57 verfahren werden.

Die Leiterplatte wird mit der im Hubtisch 48 integrierten Kamera 54 an ihrer Unterseite abgetastet. Mit Hilfe des so erfassten Kamerabildes, das an die zentrale Steuereinrichtung weitergeleitet wird, wird die Position der Leiterplatte im Teilshuttle 5 bestimmt. Optional oder alternativ kann eine Kamera zum Abtasten der Oberseite der Leiterplatte vorgesehen sein. Diese Kamera kann beispielsweise an der Transportschiene 13 angeordnet sein. Die an der Transportschiene 13 befindliche Kamera ist vorzugsweise entlang der Transportschiene verfahrbar, so dass mit dieser Kamera sowohl Leiterplatten beider Teilshuttle erfasst werden können.

Nachdem die Position der Leiterplatte 2 im Teilshuttle 5 bestimmt ist, wird die Leiterplatte 2 in den Prüfbereich 8 verfahren. Der Prüfbereich ist der streifenförmige Bereich um die Traverseneinheit 3, in dem ein beliebiger Punkt von den Prüfsonden 47 der Prüffinger 4 kontaktiert werden kann.

Die Leiterplatte 2 wird dann einem Testvorgang unterzogen, wobei die einzelnen Leiterplattentestpunkte der Leiterplatte aufeinanderfolgend mit den Prüfsonden 47 der Prüffinger 4 kontaktiert werden. Hierbei werden die Leiterbahnen der Leiterplatte auf Unterbrechungen und Kurzschlüsse getestet. Die Messungen können als ohmsche Messungen ausgeführt werden, wobei jeweils zwei Endpunkte einer Leiterbahn gleichzeitig mit einem Prüffinger kontaktiert werden. Es ist auch möglich, die Leiterbahnen kapazitiv zu vermessen, wobei dann lediglich ein einziger Prüffinger mit der Leiterbahn in Kontakt stehen muss. Eine kapazitive Messung ist vor allem bei langen Leiterbahnen zweckmäßig.

Die Leiterplatte kann sich über den Prüfbereich 8 in Bewegungsrichtung 57 hinaus erstrecken. Während des Testvorganges kann die Leiterplatte mittels des Teilshuttles 5 ein- oder mehrfach verfahren werden, um unterschiedliche Abschnitte der Leiterplatte im Prüfbereich 8 zu positionieren bzw. um die Bewegungen der Prüffinger zu optimieren, d.h., so gering wie möglich zu halten.

Vorzugsweise werden Abschnitte der Leiterplatte, welche eine hohe Dichte bzw. eine hohe Anzahl von noch zu testenden Leiterplattentestpunkten aufweisen, in Abschnitte des Prüfbereichs 8 gebracht, in welchen sich Abtastbereiche von Prüffingern zweier unterschiedlicher Führungsschienen 44 überlappen. Hierdurch können derartige Abschnitte mit hoher Dichte bzw. hoher Anzahl von noch zu testenden Leiterplattentestpunkten sehr schnell aufeinanderfolgend kontaktiert werden.

Zwischen den einzelnen Bewegungen der zu testenden Leiterplatte ist keine erneute Kalibrierung, d.h. optische Abtastung, notwendig, da die Position der Leiterplatte bezüglich der Traverseneinheit 3 bzw. der Prüffinger 4 durch die Wegmesseinrichtung präzise verfolgt wird.

Die Verfahrbarkeit der Leiterplatte bezüglich der Traverseneinheit 3 erlaubt es auch zuverlässig eine Vier-Draht-Messung oder die Kontaktpunkte eines MOS-FET zu kontaktieren, da hierbei zumindest drei oder vier Leiterplattentestpunkte gleichzeitig zu kontaktieren sind, die zudem eng aneinander liegend angeordnet sein können. Eine solche Gruppe von Leiterplattentestpunkten, die gleichzeitig zu kontaktieren sind, kann durch Verfahren des Teilshuttles 5 in den Abschnitt gebracht werden, in welchem sich die Abtastbereiche unterschiedlicher Gruppen von Prüffingern überlappen, so dass mit mehreren Prüffingern gleichzeitig hier eng benachbarte Leiterplattentestpunkte kontaktierbar sind. Dies gilt auch für gleichzeitig zu kontaktierende Leiterplattentestpunkte, die etwa auf einer Linie angeordnet sind, die parallel zur Traverseneinheit 3 verläuft, welche mit herkömmlichen Fingertestern oftmals nur schwer zu kontaktieren sind. Diese Leiterplattentestpunkte, auch wenn sie etwas weiter voneinander beabstandet sind, können durch Verfahren des Teilshuttles in den Überlappungsbereich zweiter benachbarter Abtastbereiche gebracht werden.

Während des Testvorganges mit der ersten Leiterplatte 2 im Teilshuttle 5 wird mit dem Greifarm 15 eine weitere, zweite Leiterplatte 2 in das Teilshuttle 6 eingesetzt. Die im Teilshuttle 6 eingesetzte Leiterplatte wird wiederum mit der Kamer 54 abgetastet, so dass die Position der Leiterplatte 2 im Teilshuttle 6 bestimmt ist (Kalibrierung). Das Teilshuttle 6 wird mit der zweiten Leiterplatte zum Prüfbereich 8 verfahren.

Ist der Testvorgang der ersten Leiterplatte im Wesentlichen abgeschlossen, so dass zumindest nicht mehr alle Prüffinger zum Testen der ersten Leiterplatte benötigt werden, dann beginnt der Testvorgang zum Testen der zweiten Leiterplatte, indem die nicht mehr zum Testen der ersten Leiterplatte benötigten Prüffinger zur zweiten Leiterplatte verfahren werden und an dieser aufeinanderfolgende Leiterplattentestpunkte kontaktieren.

Nach vollständigem Abschluss des Testvorganges der ersten Leiterplatte wird diese mit dem Teilshuttle 5 zurück zum Aufnahmebereich 7 verfahren. Am Aufnahmebereich 7 wird die getestete Leiterplatte 2 vom Greifarm 15 aufgenommen und zu einem der Ablagestapel 11, 12 verfahren. Der Ablagestapel 11 ist für fehlerhafte Leiterplatten und der Ablagestapel 12 für fehlerfreie Leiterplatten vorgesehen.

Der Teilshuttle 5 kann mit einer weiteren, dritten Leiterplatte beladen werden, während die zweite Leiterplatte, die sich im Teilshuttle 6 befindet, getestet wird. Die dritte Leiterplatte wird wiederum kalibriert und dann zum Prüfbereich 8 verfahren.

Somit können am Prüfbereich 8 Leiterplatten mit kurzem Abstand aufeinanderfolgend getestet werden.

Vor allem bei kleinen Leiterplatten, bei welchen der Testvorgang in kurzer Zeit abgeschlossen werden kann, verursachen bei herkömmlichen Fingertestern das Be- und Entladen und das Kalibrieren der Leiterplatte eine erhebliche Verzögerung und damit Verminderung des Durchsatzes. Dies wird mit der vorliegenden Prüfvorrichtung durch das alternierende Beschicken des Prüfbereiches 8 mittels der zwei Teilshuttle vermieden.

Mit dieser Vorrichtung können auch Leiterplatten getestet werden, die größer als der Haltebereich eines der beiden Teilshuttle 5, 6 sind. Hierzu werden die Teilshuttle so positioniert, dass jeweils die vorderen und hinteren Haltearme 18, 20 bzw. 19, 21 zueinander fluchten. Eine große, rechteckförmige Leiterplatte kann dann so in die beiden Teilshuttle 5, 6 eingesetzt werden, dass sie sich über beide Haltebereiche erstreckt und somit von beiden Teilshuttlen 5, 6 gleichzeitig gehalten werden wird. Die Teilshuttle 5, 6 werden somit als ein einzelnes Shuttle gemeinsam verwendet. Ist die Leiterplatte nicht rechteckförmig, dann kann sie dennoch von den beiden Teilshuttlen 5, 6 aufgenommen werden, wobei dann die entsprechenden Haltearme nicht fluchtend zueinander angeordnet sind.

Eine große Leiterplatte wird dann durch Verfahren der beiden Teilshuttle zum Prüfbereich 8 bewegt. Hier wird die große Leiterplatte gleichermaßen, wie es oben anhand kleiner Leiterplatten beschrieben ist, einem Testvorgang unterzogen, wobei während des Testvorganges die große Leiterplatte auch bezüglich der Traverseneinheit 3 verfahren werden kann. Auch bei einer solch großen Leiterplatte können Vier-Draht-Messungen durchgeführt werden oder andere Gruppen von gleichzeitig zu kontaktierenden Leiterplattentestpunkte gleichzeitig kontaktiert werden, selbst wenn sie eng bei einander liegen oder entlang einer Linie quer zur Bewegungsrichtung 57 angeordnet sind. Ist der Testvorgang der großen Leiterplatte abgeschlossen, dann wird die große Leiterplatte mittels der Teilshuttle 5, 6 zum Aufnahmebereich 7 verfahren. Im Aufnahmebereich 7 wird die große Leiterplatte auf die Hubtische 48 abgelegt. Eine weitere Leiterplatte kann bereits mit dem Greifarm 15 über dem Aufnahmebereich 7 vorgehalten werden. Sie wird dann vom Greifarm abgesenkt, so dass sie von den Teilshuttlen 5, 6 aufgenommen werden kann und wiederum zum Prüfbereich 8 verfahren werden kann.

Durch das Verfahren der Teilshuttle 5, 6 zum Prüfbereich liegt dann die sich auf den Hubtischen 48 befindliche Leiterplatte frei zugänglich, so dass sie vom Greifarm 15 aufgenommen und zu einem Ablagestapel 11, 12 verfahren werden kann.

Durch das Ablegen der Leiterplatte auf den Hubtischen 48 kann die zum be- und Entladen der Teilshuttle 5, 6 benötigte Zeit gegenüber herkömmlichen Verfahren erheblich verkürzt werden.

Mit dieser Prüfvorrichtung können somit sowohl kleine Leiterplatten als auch große Leiterplatten getestet werden, wobei bei kleinen Leiterplatten der Durchsatz durch das alternierende Zuführen der Leiterplatten zum Prüfbereich im Vergleich zu herkömmlichen Fingertestern erheblich gesteigert werden kann.

Zudem können durch die Einstellbarkeit des Abstandes der Haltearme zueinander unterschiedliche Typen von Leiterplatten in kurzer Folge getestet werden, wobei keine Umrüstung der Prüfvorrichtung notwendig ist, sondern lediglich der Abstand der Haltearme zueinander verändert wird. Auch können große Leiterplatten, die mit beiden Teilshuttlen transportiert werden, und kleine Leiterplatten, die nur mit einem Teilshuttle transportiert werden, ohne Umzurüsten aufeinanderfolgend getestet werden.

Diese Prüfvorrichtung ist daher auch hochflexibel und ermöglicht zudem beim Testen von kleinen Leiterplatten einen hohen Durchsatz.

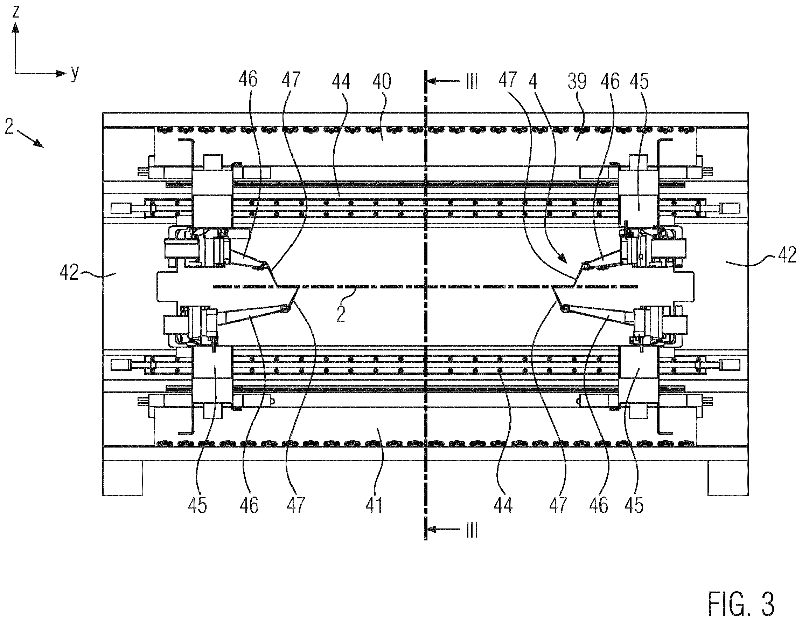

Die Erfindung ist oben anhand eines Ausführungsbeispiels einer Prüfvorrichtung mit einer einzigen Traverseneinheit 3 erläutert worden. Im Rahmen der Erfindung können auch mehrere Traverseneinheiten vorgesehen sein, wie es zum Beispiel in Figur 2 und 3 gezeigt ist. Bei dem oben erläuterten Ausführungsbeispiel sind zwei Teilshuttle 5, 6 vorgesehen. Bestimmte Aspekte der Erfindung, wie zum Beispiel das Vorsehen des Hubtisches 48 und das hierdurch ermöglichte Verfahren zum Aufnehmen einer Leiterplatte nach dem Testen derselben und zum Zuführen einer weiteren Platte von oben zu dem Shuttle können auch bei einer Prüfvorrichtung verwendet werden, welche nur ein einziges Shuttle aufweist.

Bei dem oben erläuterten Ausführungsbeispiel sind die beiden Teilshuttle 5, 6 völlig unabhängig voneinander bewegbar, sofern nicht eine Leiterplatte eingesetzt ist, die sich über die Haltebereiche beider Shuttle erstreckt. Es kann auch zweckmäßig sein, ein Koppelelement vorzusehen, das die beiden Teilshuttle mechanisch miteinander koppelt, wenn sie gemeinsam eine große Leiterplatte aufnehmen sollen.

Bei dem oben erläuterten Ausführungsbeispiel weisen die Shuttle jeweils zwei Haltearme auf, die separate Bauteile sind und separat mit einem Schlitten jeweils auf einer Shuttleschieneneinrichtung verfahrbar sind. Grundsätzlich ist es auch möglich, anstelle zweier Haltearme einen herkömmlichen Rahmen vorzusehen, der lediglich von einem einzigen Schlitten gehalten wird. Der Rahmen kann derart ausgebildet sein, dass er in der Draufsicht in etwa C-förmig ausgebildet ist, so dass er in Richtung zum anderen Shuttle hin offen ist. Hierdurch kann eine großflächige Leiterplatte in zwei, sich gegenüberliegende C-förmige Rahmen genauso wie bei den oben erläuterten Teilshuttlen eingesetzt werden.

Beim obigen Ausführungsbeispiel werden die Leiterplatten in den Teilshutteln 5, 6 mittels Halteelementen 31 so gehalten, dass sie von beiden Seiten frei zugänglich sind und beide Seiten der Leiterplatte gleichzeitig getestet werden können. Es gibt jedoch auch Prüfvorrichtungen zum einseitigen Testen einer Leiterplatte. Ein Shuttle für den einseitigen Test von Leiterplatten kann Halteelemente aufweisen, welche an der Unterseite der Leiterplatte angreifen, wie zum Beispiel ein oder mehrere Saugnäpfe.

Die Erfindung wird oben anhand eines Ausführungsbeispieles mit Traverseneinheiten erläutert, welche zumindest zwei Führungsschienen 44 aufweisen. Im Rahmen der Erfindung ist es auch möglich, die Führungsschienen in anderer Art und Weise als mit solchen Traverseneinheiten vorzusehen. Die Führungsschienen können beispielsweise jeweils an einer separaten Traverse angeordnet sein. Mehrere Führungsschienen können auch an einer gemeinsamen Platte befestigt sein. Vorzugsweise ist für das Testen einer jeden Seite der zu testenden Leiterplatte eine separate Platte mit jeweils mehreren Führungsschienen vorgesehen. Die Führungsschienen sind vorzugsweise äquidistant und parallel auf der oder den Platten angeordnet. Eine solche Platte kann beispielsweise eine Granitplatte sein.

Allen diesen Ausführungsformen ist gemeinsam, dass die Führungsschienen ortsfest angeordnet sind.

Der maximale Abstand der Führungsschienen beträgt zweckmäßigerweise nicht mehr als 300 mm, insbesondere nicht mehr als 250 mm bzw. nicht mehr als 175 mm und besonders bevorzugt nicht mehr als 125 mm. Der minimale Abstand der Führungsschienen beträgt vorzugsweise zumindest 40 mm, insbesondere zumindest 50 mm bzw. zumindest 100 mm.

### Bezugszeichenliste

- 1: Prüfvorrichtung
- 2: Leiterplatte
- 3: Traverseneinheit
- 4: Prüffinger
- 5: Teilshuttle
- 6: Teilshuttle
- 7: Aufnahmebereich
- 8: Prüfbereich
- 9: Be- und Entladeeinrichtung
- 10: Vorratsstapel
- 11: Ablagestapel
- 12: Ablagestapel
- 13: Transportschiene
- 14: Transportschlitten
- 15: Greifarm
- 16: Saugnapf
- 17: Hubeinrichtung
- 18: Haltearm
- 19: Haltearm
- 20: Haltearm
- 21: Haltearm
- 22: Schlitten
- 23: Schlitten
- 24: Schlitten
- 25: Schlitten
- 26: Shuttleschieneneinrichtung
- 27: Shuttleschieneneinrichtung
- 28: Shuttleschiene
- 29: Mittellinie
- 30: Halteeinrichtung
- 31: Halteelement
- 32: Scharniergelenk
- 33: Klemmbacken
- 34: Aufnahmegabel
- 35: Zinken
- 36: Vorsprung
- 37: Gewindespindel
- 38: Magnetelement
- 39: Rahmen
- 40: oberer Querbalken
- 41: unterer Querbalken
- 42: seitlicher Balken
- 43: Durchgangsöffnung
- 44: Führungsschiene
- 45: Positionierelement
- 46: Testfinger
- 47: Prüfsonde
- 48: Hubtisch
- 49: Hubplatte
- 50: Saugleiste
- 51: Saugloch
- 52: Gestell
- 53: Hubzylinder
- 54: Kamera
- 55: Ausnehmung
- 56: Schiene
- 57: Bewegungsrichtung

## Patentansprüche

1. Verfahren zum Prüfen einer Leiterplatte unter Verwendung einer Prüfvorrichtung zum Testen von Leiterplatten, insbesondere von unbestückten oder teilbestückten Leiterplatten, wobei die Prüfvorrichtung zumindest vier Prüffinger (4) aufweist, die zum Kontaktieren von Leiterplattentestpunkten auf einer Seite einer zu testenden Leiterplatte (2) aufweist, und die Prüffinger (4) jeweils mit einer Prüfsonde (47) versehen sind, wobei jeweils zwei der Prüffinger (4) entlang einer Führungsschiene (44) verfahrbar sind und die Prüffinger (4) um eine zu einem Prüfbereich (8) senkrecht stehende Achse drehbar sind, so dass sie mit ihren Prüfsonden (47) in einem vorbestimmten Prüfbereich (8) beliebige Punkte kontaktieren können, und die Prüffinger (4), die entlang einer gemeinsamen Führungsschiene (44) verfahrbar sind, jeweils einen streifenförmigen Abtastbereich abdecken, wobei sich die beiden Abtastbereiche der zumindest zwei Paar Prüffinger (4) etwas überlappen, und
am Prüfbereich (8) Halteelemente (31) zum Halten einer zu testenden Leiterplatte (2) vorgesehen sind,
wobei eine zu testende Leiterplatte während eines Testvorganges ein oder mehrfach quer zu Führungsschienen (44), an welchen Prüffinger verschieblich gelagert sind, bewegt wird, um die Bewegungen der Prüffinger (4) zu minimieren,
**dadurch gekennzeichnet,**
**dass** Abschnitte der Leiterplatte, welche drei oder vier gleichzeitig kontaktierbare Leiterplattentestpunkte aufweisen, jeweils in einen der Bereiche gebracht werden, in welchen sich die Abtastbereiche der Prüffinger überlappen.

2. Verfahren nach Anspruch 1,
**dadurch gekennzeichnet,**
**dass** an den drei oder vier gleichzeitig kontaktierbaren Leiterplattentestpunkte eine Vier-Draht-Messung durchgeführt wird.

3. Verfahren nach Anspruch 1 oder 2,
**dadurch gekennzeichnet,**
**dass** die zu die zu testende Leiterplatte (2) durch einen Shuttle mit zwei Haltearmen transportiert wird, an welchen Halteelemente (31) jeweils an einem Rand eines der Haltearme (18 - 21) angeordnet sind, welcher zum jeweils anderen Haltearm (18 - 21) weist, dass die Halteelemente (31) entlang dem jeweiligen Haltearm (18 - 21) verschiebbar sind.

4. Verfahren nach einem der Ansprüche 1 bis 3,
**dadurch gekennzeichnet,**
**dass** die zu testende Leiterplatte (2), welche sich in einem ersten Teilshuttle (5, 6) befindet, in einem ersten Testvorgang mittels der Prüffinger (4) abgetastet wird und gleichzeitig das andere zweite Teilshuttle (6, 5) entladen und mit einer weiteren zu testenden Leiterplatte (2) beladen wird, wobei das zweite Teilshuttle (6, 5) zum Prüfbereich (8) verfahren wird, um dort die Leiterplatte (2) mittels der Prüffinger (4) in einem zweiten Testvorgang abzutasten, wenn der erste Testvorgang im Wesentlichen abgeschlossen ist.

5. Verfahren nach einem der Ansprüche 1 bis 4,
**dadurch gekennzeichnet,**
**dass** die Leiterplatte (2) im zweiten Teilshuttle (6, 5) bevor sie der Abtastung durch die Prüffinger (4) unterzogen wird, mittels einer Kamera (54) erfasst wird, um die Position der Leiterplatte (2) bzgl. des zweiten Teilshuttles (6, 5) zu bestimmen.

6. Verfahren nach einem der Ansprüche 1 bis 5,
**dadurch gekennzeichnet,**
**dass** nach Beendigung eines Testvorganges einer ersten Leiterplatte (2) diese erste Leiterplatte (2) mittels eines oder beider Teilshuttle (5, 6) zum Aufnahmebereich (7) verfahren wird, dort auf das Aufnahmeelement (48) abgelegt oder von einem Greifarm (15) aufgenommen wird, und eine weitere zweite Leiterplatte (2) vom Greifarm (15) oder vom Aufnahmeelement (48) in einen oder beide Teilshuttle (5, 6) eingesetzt wird,
die zweite Leiterplatte (2) zum Prüfbereich (8) verfahren wird und die erste Leiterplatte (2) entweder vom Aufnahmeelement (48) im Aufnahmebereich (7) mittels des Greifarms (15) abgehoben und außerhalb des Aufnahme- und Prüfbereichs (7, 8) oder direkt mittels des Greifarms (15) abgelegt wird.

7. Verfahren nach einem der Ansprüche 1 bis 6,
**dadurch gekennzeichnet,**
**dass** Abschnitte der Leiterplatte, welche eine hohe Dichte bzw. hohe Anzahl von noch zu testenden Leiterplattentestpunkten aufweisen, in Bereiche gebracht werden, in welchen sich die Abtastbereiche der Prüffinger überlappen.

8. Verfahren nach einem der Ansprüche 1 bis 7,
**dadurch gekennzeichnet,**
**dass** die zu testende Leiterplatte (2) nur vor dem Testvorgang kalibriert wird und während des Testvorgangs die Position der Leiterplatte (2) bzgl. der Prüffinger anhand einer Wegmesseinrichtung verfolgt wird, welche einen Verschiebeweg quer zu den Führungsschienen (44) erfasst.

9. Prüfvorrichtung mit
zumindest vier Prüffinger (4), die zum Kontaktieren von Leiterplattentestpunkten auf einer Seite einer zu testenden Leiterplatte (2) angeordnet sind, und die Prüffinger (4) jeweils mit einer Prüfsonde (47) versehen sind,
wobei jeweils zwei der Prüffinger (4) entlang einer Führungsschiene (44) verfahrbar sind und die Prüffinger (4) um eine zu einem Prüfbereich (8) senkrecht stehende Achse drehbar sind, so dass sie mit ihren Prüfsonden (47) in einem vorbestimmten Prüfbereich (8) beliebige Punkte kontaktieren können, und die Prüffinger (4), die entlang einer gemeinsamen Führungsschiene (44) verfahrbar sind, jeweils einen streifenförmigen Abtastbereich abdecken, wobei sich die beiden Abtastbereiche der zumindest zwei Paar Prüffinger (4) etwas überlappen, und
am Prüfbereich (8) Halteelemente (31) zum Halten einer zu testenden Leiterplatte (2) vorgesehen sind
wobei die Halteelemente (31) mit einer Verfahreinrichtung versehen sind, mit welcher sie zusammen mit einer von der Halteeinrichtung gehaltenen Leiterplatte (2) in der Ebene des Prüfbereichs (8) und quer zu den Führungsschienen (44) verfahrbar sind.

10. Prüfvorrichtung nach Anspruch 9,
**dadurch gekennzeichnet,**
**dass** eine zentrale Steuereinrichtung vorgesehen ist, die zum Ausführen eines der Verfahren nach einem der Ansprüche 1 bis 8 ausgebildet ist.

11. Prüfvorrichtung nach Anspruch 9 oder 10,
**dadurch gekennzeichnet,**
**dass** die Führungsschienen (44) ortsfest angeordnet sind.

12. Prüfvorrichtung nach einem der Ansprüche 9 bis 11,
**dadurch gekennzeichnet,**
**dass** die Verfahreinrichtung eine Wegmesseinrichtung zum Messen des zurückgelegten Verfahrweges aufweist, wobei die Wegmesseinrichtung vorzugsweise eine Ortsauflösung von zumindest 10 µm oder weniger und insbesondere einer Ortsauflösung von zumindest 1 µm oder weniger und vorzugsweise einer Ortsauflösung von 0,1 µm oder weniger aufweist.

13. Prüfvorrichtung nach Anspruch 12,
**dadurch gekennzeichnet,**
**dass** die Wegmesseinrichtung eine optische Skala und einen optischen Sensor, die zueinander verfahrbar angeordnet sind, wobei der optische Sensor die Skala zum Erfassen des Verfahrweges abtastet.
